# EUROPEAN PATENT APPLICATION

(11) **EP 1 244 218 A1**
(43) Date of publication of application: **25.09.2002**
(21) Application number: 01107346.7
(22) Date of filing: 24.03.2001
(51) Int. Cl.: H03M 1/18

(54) **Analog-to-digital converter unit with improved resolution**

(71) Applicant: Agilent Technologies, Inc. (a Delaware corporation), Palo Alto, CA 94303 (US)
(72) Inventor: Funke, Oliver, 71134 Aidlingen (DE); Sennewald, Helmut, 71083 Herrenberg (DE)
(74) Representative: Barth, Daniel

(57) **Abstract**

An analog-to-digital conversion unit comprises a first analog-digital converter (50) receiving and converting an analog input signal (U) to a first digital output signal (C). A signal amplifier (90) receives and amplifies the analog input signal (U) by an amplification factor n, and a second analog-digital converter (100) converts the amplified analog input signal (U) to a second digital output signal (A). A processing unit (80) selects one of the first (C) and the second (A) output signals as an output of the analog-to-digital conversion unit, whereby the processing unit (80) selects the second digital output signal (A) as long as it is smaller than a given threshold value (B).

## Description

### BACKGROUND OF THE INVENTION

The present invention relates to analog-to-digital convertion.

Analog-to-digital converters or Analog-Digital converters (ADC) are frequently used in electronic circuits for converting analog signals into digital signals. Dependent on the given resolution (e.g. 12, 16, or 24 Bit) the ADC converts the analog signals into digital signals, each representing a discrete signal level.

Although some applications of ADCs require higher resolution, the presently available ADCs with such higher resolution (e.g. greater than 16 Bit) are not fast enough to allow such application. One solution to overcome such limited ADC resolution in (e.g. measurement) applications is to switch between different (measuring) ranges instead of covering a larger range with one ADC having a larger resolution. This, however, is disadvantageous since switching between different measuring ranges generally leads to a certain transition behavior which may take too long time.

### SUMMARY OF THE INVENTION

It is an object of the present invention to provide an improved analog to digital conversion. The object is solved by the independent claims. Preferred embodiments are shown by the dependent claims.

According to the invention, an analog input signal is provided in a first signal path to a first analog-digital converter (ADC). The analog input signal is further provided, in a second signal path, to a signal amplifier amplifying the analog signal by a given factor n and providing the amplified input signal to a second ADC. The outputs of the first and second ADC, which now represent digital signals, are then provided to a processing unit.

The processing unit selects one of the outputs of the first or second ADC, whereby the output of the second ADC is selected as long as it is within its operating conversion range or, in other words, as long as the output of the second ADC is smaller than a given threshold value. Otherwise, the processing unit selects the output of the first ADC.

It is apparent that although the outputs of the first and seconds ADCs both represent the same signal, i.e. the input signal, the levels of the outputs of the first and the second ADC are not the same due to the amplification provided by the amplifier in the second signal path. Dependent on the specific application, the processing unit might therefore fulfill a second task to level the output signals from the first and second ADC, so that the processing unit will provide the selected output signal at the same level irrespective whether it originates from the first or the second ADC. It is clear that the order of the two tasks provided by the processing unit might vary dependent on the specific application.

This second task of signal leveling is preferably provided by multiplying the digital output of the first ADC by a multiplication factor k substantially equaling factor n for amplifying the analog input signal in the second signal path. Then, both signals provided either by the first or the second ADC are substantially at the same level.

Instead of multiplying the output of the first ADC, the digital output signal provided by the second ADC can also be divided by the factor k, again substantially equaling the amplification factor n of the amplifier accordingly.

It is clear, however, that the second task of signal leveling is not necessary for the execution of the improved analog digital conversion according to the invention, but provides an improved embodiment only.

The amplification factor n of the amplifier has to be selected in a way that the linear conversion ranges of the first and second ADC overlap to a certain extend. Due to the amplified signal received by the second ADC, the effective sensitivity of the second ADC is increased for lower levels of the input signal. On the other hand, for higher levels of the input signal, the applicable conversion range of the second ADC will be exceeded. However, in case the applicable conversion ranges of the first and second ADCs overlap, and as long as the conversion range of the first ADC is not exceeded, this output of the first ADC will be selected. Since the resolution of the second ADC is maintained over its entire applicable range, and in addition to that, the non-overlapping range of the first ADC will be utilized with the resolution of the first ADC, the effective resolution of the entire analog to digital conversion unit in accordance with the present invention is a combination of the resolutions of the first and second ADCs and thus greater than the resolution of either one of the first or second ADC.

In an example, wherein the resolution of the first and second ADC is 2^{M}, and the amplification factor of the amplifier is n = 2^{N}, whereby N < M, the effective resolution of the analog to digital conversion according to the invention is (n·2^{M}) Bit. In an example, wherein the resolution of both ADCs is 16 Bit and the amplification factor is 16, the effective resolution will be 20 Bit.

Selecting the output of the second ADC throughout its applicable range and selecting the output of the first ADC otherwise (within the applicable range of the first ADC) ensures that the relative error of the analog to digital conversion is minimized. However, it is clear that this selection scheme is not essential for the invention but provides an improved embodiment. It is clear that also the output of the first ADC can have priority over the output of the second ADC.

In case that offset levels occur in either one or both of the two signal paths, an offset correction can be provided by providing a reference measurement (generally without an applied input signal) and determining offset values for each of the two signal paths. The offset levels of each signal path might then be compensated (either physically in the amplifier path or by calculation).

In case that the value of the amplification factor n deviates from the multiplication factor k as provided for the leveling of the outputs of the first and second ADC, a reference measurement might be provided in order to determine the actual amplification factor. The actual amplification factor n might then be adjusted to the multiplication factor k, e.g. by providing a fine-tuning for the amplifier, or the multiplication factor k has to be adjusted according to the measured amplification factor n. It is to be understood that the multiplication factor for the signal leveling is normally selected to be a binary integer value (e.g. 2, 4, 8, 16, ....) in order to limit the effort for calculation. In contrast thereto, the amplification factor of the amplifier will be determined by analog properties and might therefore vary over a wide range of numbers and also cover non-integer values.

It is clear that the invention can be partly or entirely embodied or supported by one or more suitable software programs, which can be stored on or otherwise provided by any kind of data carrier, and which might be executed in or by any suitable data processing unit.

### BRIEF DESCRIPTION OF THE DRAWINGS

Other objects and many of the attendant advantages of the present invention will be readily appreciated and become better understood by reference to the following detailed description when considering in connection with the accompanied drawings. Features that are substantially or functionally equal or similar will be referred to with the same reference sign(s).
- Figure 1: shows a preferred embodiment for an analog to digital conversion in accordance with the present invention for an application example in an optical power meter.
- Figure 2: shows a representation of the analog to digital conversion provided by the circuit of Figure 1

### DETAILED DESCRIPTION OF THE INVENTION

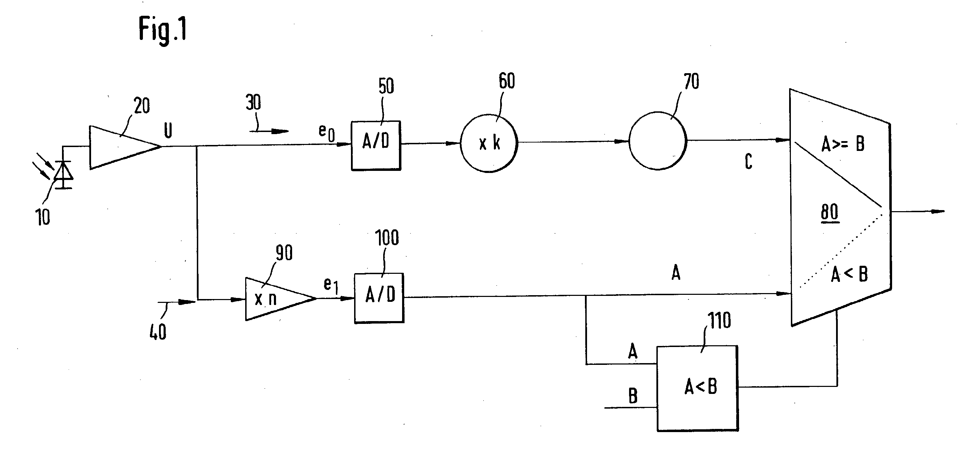

In Fig. 1, a receiver diode 10 receives an optical signal and converts that optical signal into a voltage signal dependent on the optical power. A receiver diode 10 is connected to a transimpedance amplifier (TIA) 20, thus providing an input stage.

The output of the TIA 20 provides input for a first signal path 30 and a second input path 40. The first input path 30 is comprised of a series connection of a first ADC 50, a multiplier 60, and an offset unit 70. The first ADC 50 converts the analog signal provided at the output of the TIA 10 into a first digital signal provided at its output. The multiplier 60 multiplies the digital output from the ADC 50 by a multiplication factor k. The offset unit 70 provides an offset correction (as will be explained later) to the multiplied output of the multiplier 60 and provides the offset-corrected signal C to a selection unit 80.

In the second signal path 50, a second amplifier 90 amplifies the output signal of the first TIA 20 by an amplification factor n. The amplified signal from the second amplifier 90 is then converted by a second ADC 100 into a second digital output signal A and coupled as a second input to the selection unit 80.

The second digital output provided by the second ADC 100 is further coupled to a comparator 110 comparing the second digital output signal A with a given threshold value B. The output of the comparator 110 provides a control signal for the selection unit 80, whereby the selection unit 80 will select as its output the second digital output signal A in case that A < B, and will select the first digital output signal C (from the first signal path) otherwise (in case that A > = B).

The threshold value B is preferably selected as the largest digital value provided by the second ADC 100. In that case, the selecting unit 80 will select the output A of the second ADC 100 throughout its entire range of applicable values and select the second digital output signal C only for such values where the applicable range of the second ADC 100 will be exceeded.

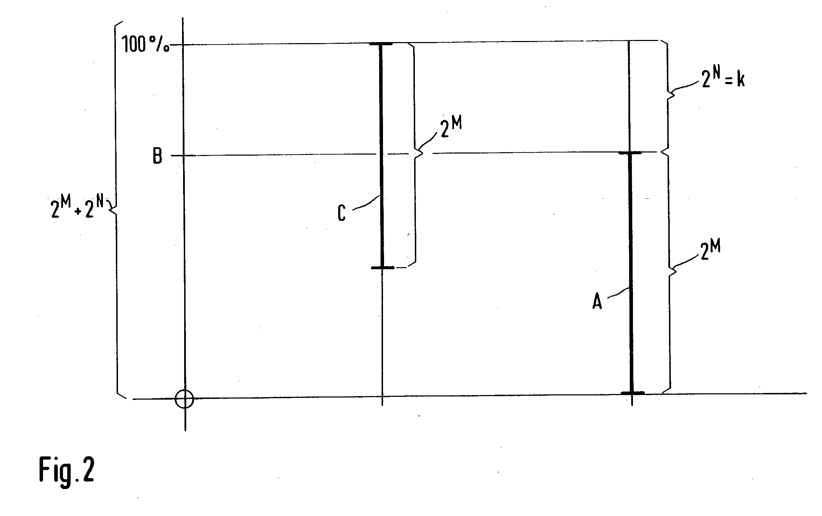

Figure 2 shows a representation of the analog to digital conversion provided by the circuit of Figure 1. Assuming that the resolution for both of the ADCs 50 and 100 is selected to be 2^{M} (or M Bits), and that the threshold B is selected as the largest applicable value of the ADC 100, the effective resolution for the analog to digital conversion of Figure 1 results in (n·2^{M}), whereby n = 2^{N}. In an example with a resolution of 16 Bit for both ADCs 50 and 100 and an amplification n = 16 = 2⁴, the effective resolution results into 16 + 4 = 20 Bit.

It is clear that though the effective resolution of the analog to digital conversion can be thus increased, the effective conversion speed, which is determined by the conversion speed of each ADC 50 and 100, remains the same as for each individual ADC 50 or 100.

The functionality of the offset unit 70 shall now be illustrated. Due to different offset voltages e₀ and e₁ at the input of ADC 50 and 100, the voltage level U at the output of the TIA 20 will be provided as at the input of the first ADC 50 and as () at the input of the second ADC 100. The multiplier 60 multiplies the output of the first ADC 50 to. In order to provide the signal C at the same level as the signal A (whereby it is assumed that n = k) the offset unit 70 needs to provide an offset of to be added to the output from the multiplier 60. Of course there are many other ways to compensate for the offset, either on analogue or digital part.

It is clear that the offset levels e₀ and e₁ can be determined by reference measurements as well known in the art. The offset unit 70 can be an offset register as also well known in the art.

In order to provide output signals C and A at the same level, the amplification factor n, which normally can be adjusted within a certain range, should at least substantially equal the multiplication factor k. Reference measurements might also be applied for determining and adjusting the amplification factor n to the multiplication factor k.

It is clear that although Figure 1 has been explained for the example of an optical power meter, the principal of the invention as provided by the first and second signal paths 40 and 50 together with the selection unit 90 are applicable to any other application.

## Claims

1. An analog-to-digital conversion unit, comprising:
a first analog-digital converter (50) adapted for receiving and converting an analog input signal (U) to a first digital output signal (C),
a signal amplifier (90) adapted for receiving the analog input signal (U) and for amplifying the analog input signal (U) by an amplification factor n,
a second analog-digital converter (100) adapted for receiving and converting the amplified analog input signal (U) to a second digital output signal (A),
a processing unit (80) adapted for receiving the first (C) and the second (A) digital output signals, and for selecting one of the first (C) and the second (A) output signals as an output of the analog-to-digital conversion unit, whereby the processing unit (80) selects the second digital output signal (A) as long as it is smaller than a given threshold value (B).

2. The analog-to-digital conversion unit of claim 1, further comprising a signal leveling unit (60) for providing the first (C) and the second (A) output signals at substantially the same level.

3. The analog-to-digital conversion unit of claim 2, wherein the signal leveling unit (60) comprises multiplying unit (60) for multiplying the first digital output signal (C) by a multiplication factor k substantially equaling the amplification factor n.

4. The analog-to-digital conversion unit according to claim 1 or any one of the above claims, wherein the amplification factor n is selected in a way that linear conversion ranges of the first (50) and the second (100) analog-digital converters overlap to a certain extend.

5. The analog-to-digital conversion unit according to claim 1 or any one of the above claims, wherein the threshold value (B) is selected to equal or be smaller than a maximum value of the linear conversion range of the second analog-digital converter (100).

6. The analog-to-digital conversion unit according to claim 1 or any one of the above claims, further comprising an offset correction unit (70) for correcting an offset in the inputs of the first (50) and the second (100) analog-digital converters.

7. A method to provide an analog-to-digital conversion, comprising the steps of:
(a) converting an analog input signal (U) to a first digital output signal (C),
(b) amplifying the analog input signal (U) by an amplification factor n,
(c) converting the amplified analog input signal (U) to a second digital output signal (A), and
(d) selecting one of the first (C) and the second (A) output signals as an output, whereby the second digital output signal (A) is selected as long as it is smaller than a given threshold value (B).

8. The method of claim 7, further comprising a step of leveling the first (C) and the second (A) output signals to substantially the same level.

9. The method of claim 7 or 8, further comprising a step prior to step (d) of multiplying the first digital output signal (C) by a multiplication factor k substantially equaling the amplification factor n.

10. A software program or product, preferably stored on a data carrier, for executing the method of claims 7-9 when run on a data processing system such as a computer.
